# EUROPEAN PATENT APPLICATION

(11) **EP 1 981 090 A1**
(43) Date of publication of application: **15.10.2008**
(21) Application number: 07706969.8
(22) Date of filing: 18.01.2007
(51) Int. Cl.: H01L 31/042

(54) **INTERCONNECTOR, SOLAR BATTERY STRING USING SUCH INTERCONNECTOR, METHOD FOR MANUFACTURING SUCH SOLAR BATTERY STRING AND SOLAR BATTERY MODULE USING SUCH SOLAR BATTERY STRING**

(30) Priority: 27.01.2006 JP 2006019342
(71) Applicant: Sharp Kabushiki Kaisha, Osaka-shi, Osaka 545-8522 (JP)
(72) Inventor: KATAYAMA, Yoshio, Hiroshima 739-0144 (JP); UMETANI, Yoshinobu, Nara 635-0055 (JP); OHBASAMI, Masahiro, Nara 639-0252 (JP)
(74) Representative: Müller - Hoffmann & Partner
(86) International application number: PCT/JP2007/050665
(87) International publication number: WO 2007/086300

(57) **Abstract**

An interconnector (1) includes a strip-shaped and electrically conductive member (3) electrically connecting respective electrodes of adjacent solar cells (2), the conductive member (3) includes a plurality of planar stress relief parts (X1) and the stress relief parts (X1) are formed at equal pitches. With this structure, a stress due to a difference in thermal expansion coefficient between the interconnector (1) and the solar cell (2) is uniformly alleviated, so that the warp occurring to the solar cell (2) is reduced and the reliability of the connection between the interconnector (1) and the solar cell (2) is improved.

## Description

### TECHNICAL FIELD

The present invention relates to an interconnector connecting solar cells to each other, a solar cell string using the interconnector and a method of manufacturing the solar cell string, and a solar cell module using the solar cell string. More specifically, the invention relates to an interconnector with which a warp that occurs to each solar cell when the solar cells are connected by the interconnector can be reduced.

### BACKGROUND ART

For solar cells converting solar energy directly into electrical energy, recently expectations have been remarkably growing for their availability as a next-generation energy source, particularly in terms of global environmental issues. Solar cells are classified into various kinds like the one using a compound semiconductor or the one using an organic material. Currently most solar cells use a silicon crystal. As photovoltaic power generation systems become rapidly widespread, reduction of the manufacturing cost of the solar cell becomes indispensable. For reducing the manufacturing cost of the solar cell, it is significantly effective to increase the size and reduce the thickness of a silicon wafer which is the substrate material.

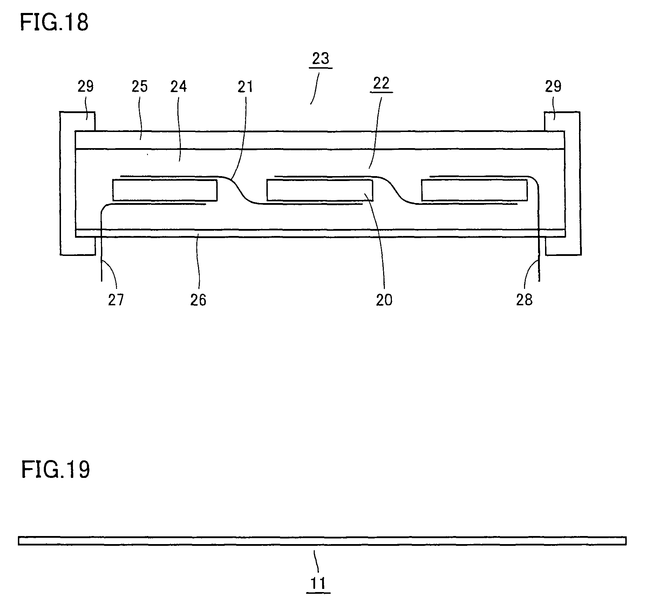

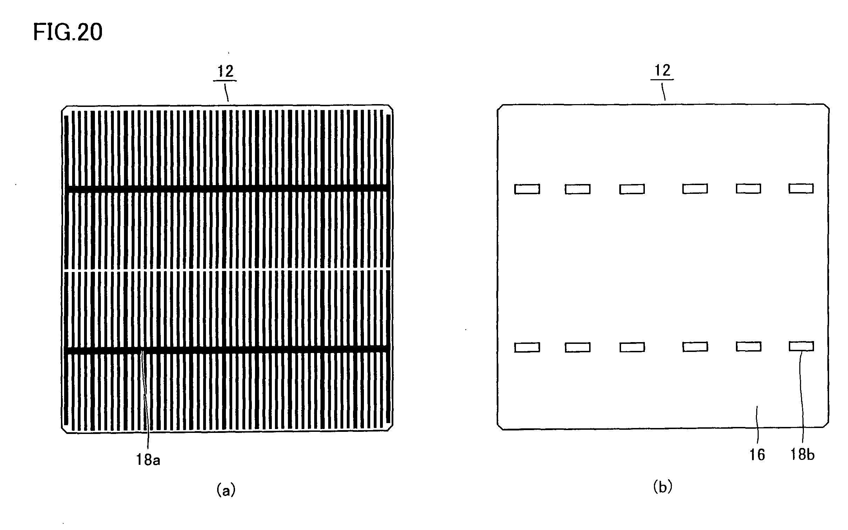

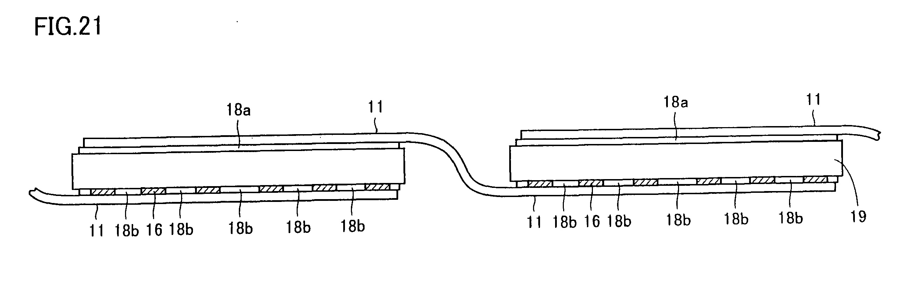

An increased size and a reduced thickness of the silicon wafer, however, are accompanied by the following problem. It is supposed that a conventionally employed interconnector (a long and thin electrically conductive member for electrically connecting solar cells adjacent to each other, see an interconnector 11 in Fig. 19) and electrodes (see electrodes 18a, 18b of Figs. 20, 21) of solar cells are used as they are for fabricating a solar cell string 22 (see Fig. 18). In a heating process for connecting the electrode of the solar cell and the interconnector, there is a difference in thermal expansion coefficient between silicon which is the substrate material for the solar cell and copper which is the base material for the interconnector. As the temperature is decreased to room temperature, the solar cell is caused to warp considerably.

Further, the warp occurring to the solar cell causes a transport error and a crack of the cell in a transport system included in an automated module fabrication line. Furthermore, in the state where a plurality of solar cells are electrically connected by an interconnector (hereinafter referred to as "string" for the present invention), if each solar cell has a warp, a local strong force is applied to each solar cell, which forms a part of the string, in a resin encapsulation process for fabricating a module, and this force causes the solar cell to crack.

In order to address this problem, an interconnector is proposed (see for example Japanese Patent Laying-Open No. 2005-142282 (Patent Document 1) that includes a long and thin electrically conductive member for electrically connecting respective electrodes of solar cells adjacent to each other. The conductive member of the interconnector disclosed in this document has its opposite ends that are connecting portions connected to the electrodes of the solar cells. At least one of the connecting portions has a plurality of small cross-section parts where the cross-sectional area is locally decreased.

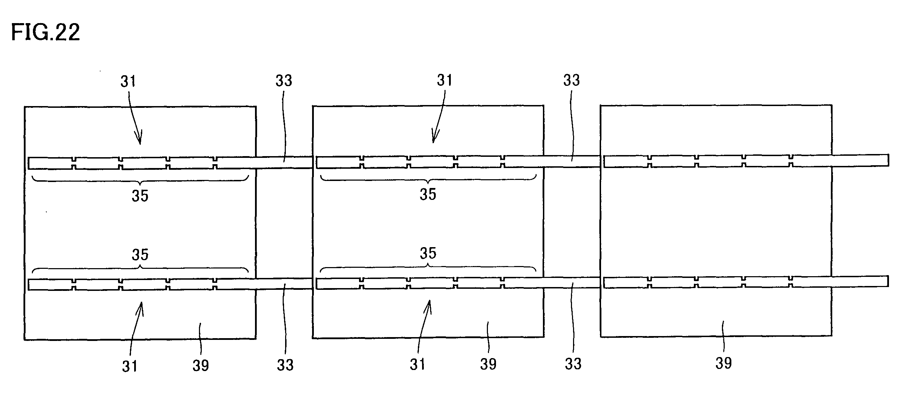

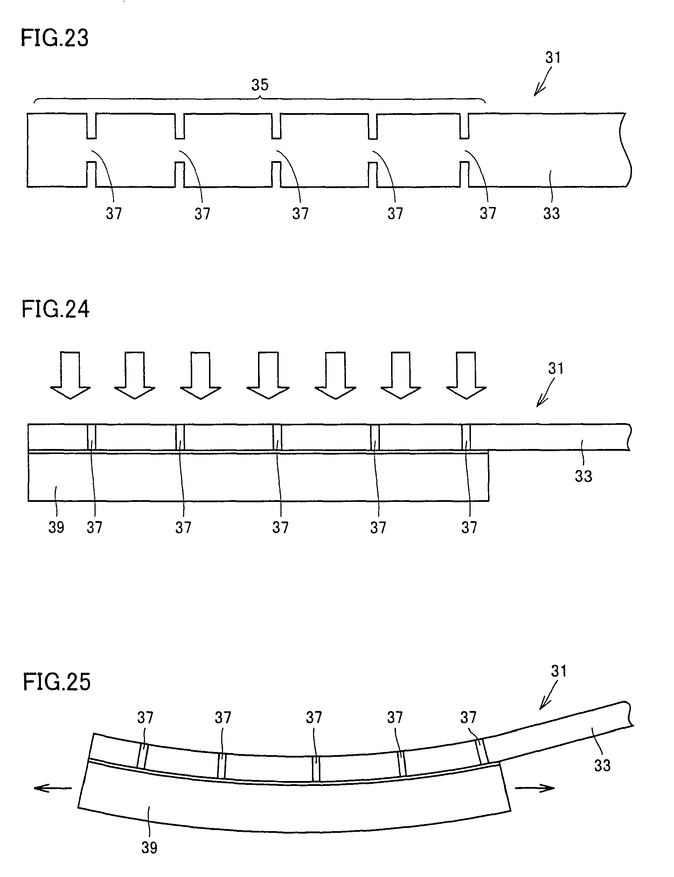

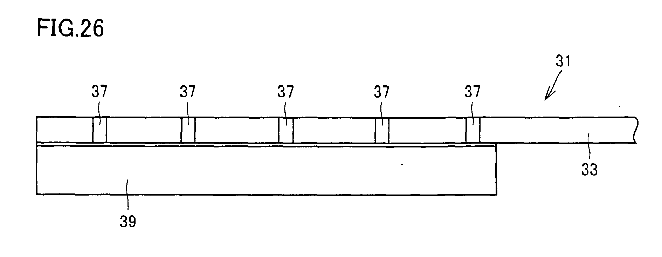

In the case where such an interconnector is used where at least one of the connecting portions of the interconnector has small cross-section parts arranged side by side in the longitudinal direction of the conductive member, the small cross-section parts having a relatively lower strength as compared with other parts are extended because of the force of recovering the original shape of the solar cell. As a consequence of this, a warp occurring to the solar cell is reduced (see Figs. 22 to 26).

In addition, since the warp of the solar cell is reduced by the extension of the small cross-section parts as described above, the connecting portion of the interconnector can be joined to the entire surface of the electrode of the solar cell regardless of a thermal stress applied to the solar cell, and thus the reliability after the cells are connected is enhanced.
Patent Document 1: Japanese Patent Laying-Open No. 2005-142282

### DISCLOSURE OF THE INVENTION

### PROBLEMS TO BE SOLVED BY THE INVENTION

In the case where the above-described interconnector is used, the intervals (pitches) between small cross-section parts each having a locally reduced cross-sectional area in the interconnector are equal pitches in the connecting portion where the interconnector is connected to the electrode of the solar cell. However, in the region from one end to the other end of the interconnector, the pitches are not equal pitches but asymmetrical. Therefore, molding of the interconnector is complicated, or handling of the interconnector such as orientation of the interconnector is complicated when the interconnector is connected to the solar cell. For example, in the case where a plurality of electrically conductive members in continuous state are cut into individual conductive members and then fed in a manufacturing process of a solar cell module, it is necessary to identify non-uniformly arranged small cross-section parts and, based on this identification, to determine the position to be located at an end of the conductive member, namely the position where the continuous conductive member is to be cut into individual conductive members. A resultant problem is that the process of feeding the interconnector is complicated. Accordingly, there is the problem that the manufacturing cost of the interconnector itself as well as the manufacturing costs of the solar cell string and the solar cell module increase due to the complicated identification process or the complicated working process.

Further, when the above-described interconnector is fed, if some region includes small cross-section parts and some region includes no small cross-section part, the force required for transportation of the interconnector could be concentrated on the locally reduced small cross-section parts. A problem here is that damage and deformation occur to the interconnector, resulting in a defective product.

Furthermore, an interconnector having a long and thin electrically conductive member can be easily stored in continuously reeled stated. When the interconnector is reeled or unreeled, however, a force could be locally concentrated on the interconnector. Specifically, when the above-described interconnector including a region where small cross-section parts are provided and a region without small cross-section parts is fed, the force required to transport the interconnector is concentrated on the region where locally reduced small cross-section parts are provided, which causes damage and deformation to the interconnector, resulting in a defective product.

The present invention has been made in view of the conditions as described above, and an object of the present invention is to provide an interconnector with which handling of the interconnector is facilitated, the manufacturing cost is reduced and defective products can be decreased, and to provide a solar cell string using the interconnector, a solar cell module and a method of manufacturing thereof.

### MEANS FOR SOLVING THE PROBLEMS

In an aspect, an interconnector of the present invention to solve the above-described problems includes a strip-shaped and electrically conductive member electrically connecting respective electrodes of adjacent solar cells, the conductive member includes a plurality of stress relief parts and the stress relief parts are formed at equal pitches.

In an embodiment of the interconnector of the present invention, the conductive member includes a plurality of planar stress relief parts. The stress relief parts are formed at regular intervals from one end to the other end of the conductive member.

In another aspect, the interconnector of the present invention includes a plurality of conductive members continuously stored in reeled state, and the stress relief parts are arranged at regular intervals.

A solar cell string to which the above-described interconnector is applied includes solar cells including respective electrodes and adjacent to each other and the interconnector electrically connecting the electrodes of the solar cells adjacent to each other.

A method of manufacturing the solar cell string of the present invention includes the step of connecting an electrode of a solar cell and the interconnector by any one of heater heating, lamp heating and reflow method.

A solar cell module of the present invention includes an encapsulating material encapsulating the solar cell string and a pair of external terminals extending outward from the solar cell string through the encapsulating material.

### EFFECTS OF THE INVENTION

According to the present invention, a stress due to a difference in thermal expansion coefficient between the interconnector and the solar cell is uniformly alleviated. Consequently, a warp occurring to the solar cell is reduced and the reliability of connection between the interconnector and the solar cell is improved. Further, stress relief parts are planer and formed at regular intervals from one end to the other end of the conductive member, so that handling of the interconnector is facilitated, damage and deformation or the like of the interconnector itself are reduced, and the manufacturing cost can be reduced.

Further, since the warp of the solar cell is reduced as described above, a transportation error and a cell crack in a transport system of a module fabrication line are prevented from occurring. Furthermore, since a cell crack in a resin encapsulation process for fabricating a module is also prevented, the yield and productivity of the solar cell module are improved.

Moreover, since the damage and the deformation of the interconnector are reduced, the transport error and the cell crack in the transport system of the module fabrication line are prevented from occurring. In addition, since the cell crack in the resin encapsulation process for fabricating a module is also prevented, the yield and productivity of the solar cell module are improved.

Moreover, since breakage of the interconnector in such a process as setting process, heat treatment process or resin encapsulation process for fabricating a module is also prevented, the yield and productivity of the solar cell module are improved.

### BRIEF DESCRIPTION OF THE DRAWINGS

Fig. 1 shows an example of the shape of a small cross-section part in the case where a lateral cross section of a conductive member is rectangular, (a) is a front view, (b) is a side view and (c) is a bottom view.
Fig. 2 shows an example of the shape of a small cross-section part in the case where a lateral cross section of a conductive member is rectangular, (a) is a front view, (b) is a side view and (c) is a bottom view.
Fig. 3 shows an example of the shape of a small cross-section part in the case where a lateral cross section of a conductive member is rectangular, (a) is a front view, (b) is a side view, (c) is a bottom view and (d) is an enlarged view of a stress relief part.
Fig. 4 shows an example of the shape of a small cross-section part in the case where a lateral cross section of a conductive member is rectangular, (a) is a front view, (b) is a side view and (c) is a bottom view.
Fig. 5 shows an example of the shape of a small cross-section part in the case where a lateral cross section of a conductive member is rectangular, (a) is a front view, (b) is a side view and (c) is a bottom view.
Fig. 6 shows an example of the shape of a small cross-section part in the case where a lateral cross section of a conductive member is rectangular, (a) is a front view, (b) is a side view and (c) is a bottom view.
Fig. 7 shows an example of the shape of a small cross-section part in the case where a lateral cross section of a conductive member is rectangular, (a) is a front view, (b) is a side view and (c) is a bottom view.
Fig. 8 shows an example of the shape of a small cross-section part in the case where a lateral cross section of a conductive member is rectangular, (a) is a front view, (b) is a side view and (c) is a bottom view.
Fig. 9 shows an example of the shape of a small cross-section part in the case where a lateral cross section of a conductive member is rectangular, (a) is a front view, (b) is a side view and (c) is a bottom view.
Fig. 10 shows an example of the shape of a small cross-section part in the case where a lateral cross section of a conductive member is rectangular, (a) is a front view, (b) is a side view and (c) is a bottom view.
Fig. 11 shows an example of the shape of a small cross-section part in the case where a lateral cross section of a conductive member is rectangular, (a) is a front view, (b) is a side view and (c) is a bottom view.
Fig. 12 shows an example of the shape of a small cross-section part in the case where a lateral cross section of a conductive member is rectangular, (a) is a front view, (b) is a side view and (c) is a bottom view.
Fig. 13 shows an example of the shape of a small cross-section part in the case where a lateral cross section of a conductive member is rectangular, (a) is a front view, (b) is a side view and (c) is a bottom view.
Fig. 14 shows an example of the shape of a small cross-section part in the case where a lateral cross section of a conductive member is rectangular, (a) is a front view, (b) is a side view and (c) is a bottom view.
Fig. 15 (a) is a plan view showing an interconnector according to a first embodiment of the present invention, (b) and (c) are diagrams illustrating arrangement of electrodes on a light-receiving surface and a rear surface of solar cells, and (d) is a diagram illustrating a state where the interconnector shown in (a) is connected to light-receiving surface electrodes and rear electrodes of the solar cells shown in (b) and (c).
Fig. 16 (a) is a plan view showing an interconnector according to a second embodiment of the present invention, (b) and (c) are diagrams illustrating arrangement of electrodes on a light-receiving surface and a rear surface of solar cells, and (d) is a diagram illustrating a state where the interconnector shown in (a) is connected to light-receiving surface electrodes and rear electrodes of the solar cells shown in (b) and (c).
Fig. 17 (a) is a plan view showing an interconnector according to a third embodiment of the present invention, (b) and (c) are diagrams illustrating arrangement of electrodes on a light-receiving surface and a rear surface of solar cells, and (d) is a diagram illustrating a state where the interconnector shown in (a) is connected to light-receiving surface electrodes and rear electrodes of the solar cells shown in (b) and (c).
Fig. 18 is a diagram illustrating a solar cell module according to the present invention.
Fig. 19 is a plan view showing an example of a conventional interconnector.
Fig. 20 shows an example of a conventional solar cell, (a) shows a front side and (b) shows a rear side.
Fig. 21 is a diagram illustrating a conventional solar cell string.
Fig. 22 shows solar cells connected by a conventional interconnector.
Fig. 23 is an enlarged view of a connecting portion of the conventional interconnector.
Fig. 24 is a diagram illustrating the manner of applying heat and thereby joining the conventional interconnector to an electrode of a solar cell.
Fig. 25 is a diagram illustrating a state where the conventional interconnector joined by applying heat is cooled to room temperature, and accordingly a warp occurs to the solar cell.
Fig. 26 is a diagram illustrating a state where small cross-section parts of the conventional interconnector extend to reduce the warp of the solar cell.

### DESCRIPTION OF THE REFERENCE SIGNS

1, 11, 21, 31 interconnector, 2, 12, 20 solar cell, 3, 33 conductive member, 3a, 3b side surface of conductive member, 6, 16 aluminum electrode, 7, 37 small cross-section part, 8a, 18a light-receiving surface electrode, 8b, 18b, rear electrode, 9, 19, 39 solar cell, 22 solar cell string, 23 solar cell module, 24 encapsulating material, 25 surface protection layer, 26 rear film, 27, 28 external terminal, 29 frame, 35 connecting portion

### BEST MODES FOR CARRYING OUT THE INVENTION

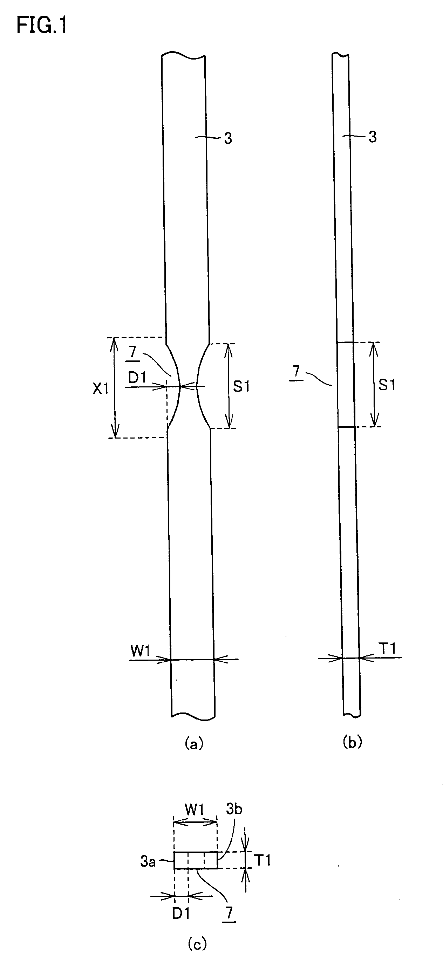

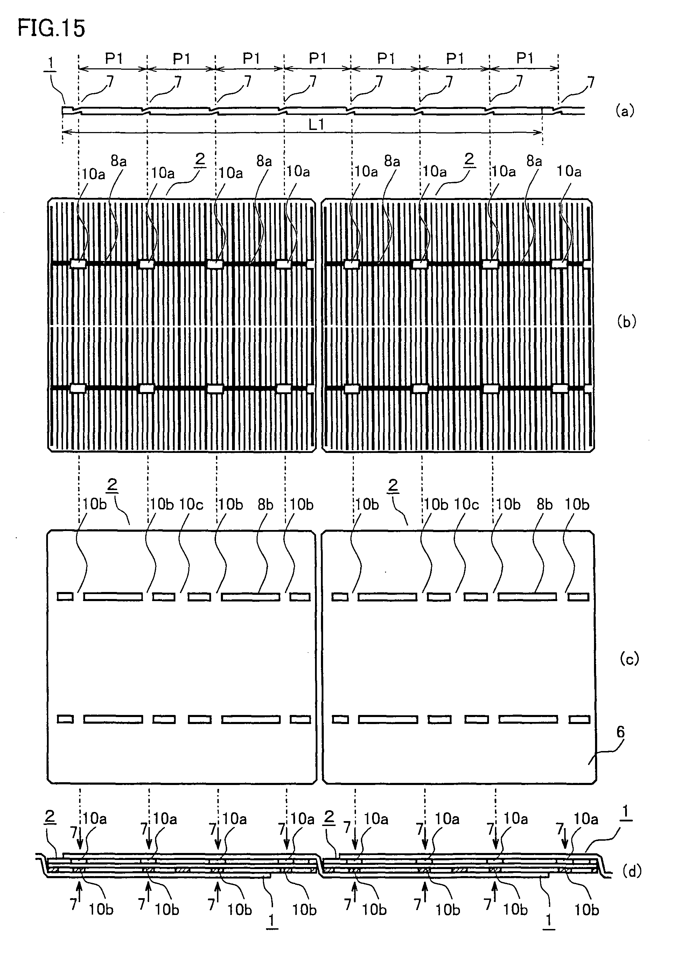

In the following, embodiments of the present invention will be described with reference to the drawings. An interconnector 1 in an embodiment of the present invention as shown in Fig. 15 for example connects solar cells 2 having an electrode on a front surface or rear surface of a semiconductor substrate, and includes a strip-shaped and electrically conductive member 3 (see Fig. 1 for example) electrically connecting respective electrodes to each other of solar cells 2 adjacent to each other. The conductive member includes a plurality of planer stress relief parts where a small cross-section part 7 is provided, and the stress relief parts are formed at regular intervals from one end to the other end of the conductive member.

Preferably, conductive member 3 of the interconnector of the present invention is formed in linear shape. More preferably, the stress relief parts are formed in planar shape and can be arranged in parallel with respect to a surface of the solar cell without a space therebetween. Conductive member 3 is provided with at least one stress relief part alleviating expansion and contraction stresses, and the stress relief part of the interconnector is structured such that the stress relief part is unlikely to be caught on something. Still preferably, in order to prevent a force from being concentrated locally in the stress relief part, the stress relief part has its cross section whose cross-sectional area continuously changes in the longitudinal direction of the interconnector. Alternatively, in order to prevent a force from being concentrated locally in the stress relief part, the stress relief part has its cross section whose cross-sectional area is divided.

Further, it is desirable to provide notches arranged in the interconnector such that an expansion or contraction stress at the stress relief part is exerted obliquely relative to the longitudinal direction. Furthermore, it is desirable to use an interconnector including notches arranged such that an expansion or contraction stress at the stress relief part is dispersed. Moreover, preferably the stress relief part of the interconnector corresponds to an electrode pattern of a solar cell, and desirably the stress relief part is not physically connected to an electrode of a solar cell.

Here, a solar cell 2 includes those formed using an elemental semiconductor such as amorphous silicon, polycrystalline silicon and monocrystalline silicon and a compound semiconductor such as GaAs, for example. Preferably, conductive member 3 is made of a strip-shaped conductor in the form of a foil or sheet, and made of a conductor formed such that the member can be stored in reeled state. In the case where the conductive member is strip-shaped, its width W is preferably approximately 0.5 to 5.0 mm, more preferably approximately 0.5 to 3.0 mm and particularly preferably approximately 2.5 mm. Thickness T is preferably approximately 0.05 to 0.5 mm, more preferably approximately 0.05 to 0.3 mm and particularly preferably approximately 0.2 mm.

One end or both ends of conductive member 3 may be divided into multiple portions. For example, in the case where one of solar cells adjacent to each other has its light-receiving surface where a plurality of electrodes are provided and the other solar cell has its rear surface where one electrode is provided, preferably an interconnector is used that is formed using a conductive member having one end divided into a plurality of portions. Conductive member 3 includes various metals and alloys for example. Specifically, conductive member 3 includes metals such as Au, Ag, Cu, Pt, Al, Ni and Ti as well as alloys of them. In particular, Cu is preferably used. Preferably, the conductive member is solder-plated. A solder-plated interconnector is surely connected with a silver electrode of a solar cell. Solder plating may be applied after a small cross-section part is formed or before a small cross-section part is formed.

Each small cross-section part 7 refers to a portion having a cross-sectional area smaller than that of most parts of the interconnector. Specifically, the small cross-section part refers to a small-width portion or a small-diameter portion formed by cutting out a part of a connecting portion. A method of cutting out a part of the connecting portion includes a method using mechanical cutting or polishing, a method using punching with a die and a method performing etching, for example. Since small cross-section part 7 has a lower strength against expansion and contraction stresses as compared with most parts of the interconnector, the small cross-section part is extended by a relatively weak force. Therefore, the small cross-section part contributes to reduction of a warp of the solar cell by extension caused by the resilience of the solar cell of recovering its original shape.

Although increase of the electrical resistance of the interconnector as a result of providing a small cross-section part may be a concern, the length of each small cross-section part in the longitudinal direction of the conductive member may be made significantly smaller relative to the whole length of the interconnector so as to reduce the increase of the electrical resistance of the interconnector as a whole to an ignorable degree. A small cross-section part may be formed between solar cells adjacent to each other. Thus, in the case where the distance between the solar cells adjacent to each other changes, the small cross-section part extends to alleviate a stress applied between the solar cells and the interconnector

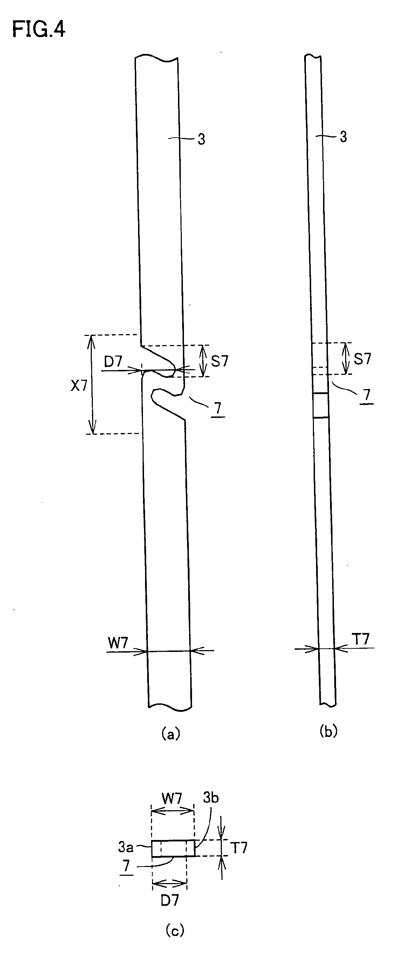

The small cross-section part may have any of the shapes for example shown in Figs. 1 to 14. Figs. 1 to 3 show examples of the shape where a conductive member has a rectangular cross section, and a pair of notches formed by being cut out from opposite side surfaces of the conductive member for example form a small cross-section part. Figs. 4 to 14 show examples of the shape where a conductive member has a rectangular cross section, and notches formed inside the interconnector form a small cross-section part. In Figs. 1 to 14 each, (a) shows a front view of the connecting portion, (b) shows a side view of the connecting portion and (c) shows a bottom view of the connecting portion.

As shown in Fig. 1 (a), (b) and (c), small cross-section part 7 is formed by cutting out two opposite side surfaces 3a and 3b of conductive member 3 such that the side surfaces are curved toward each other with a dimension in the longitudinal direction of the interconnector of S 1 and a dimension in the widthwise direction thereof of D1. Accordingly, a stress relief part X1 has its cross section whose cross-sectional area continuously changes in the longitudinal direction of the interconnector.

Here, in the case where the conductive member is sheet-shaped and has its width W1 of approximately 2.5 mm and its thickness T1 of approximately 0.20 mm, it is particularly preferable that S1 is approximately 2 to 5 mm and D1 is approximately 0.5 to 1.0 mm. Preferably, a minimum width of small cross-section part 7 is approximately 0.5 to 1.5 mm.

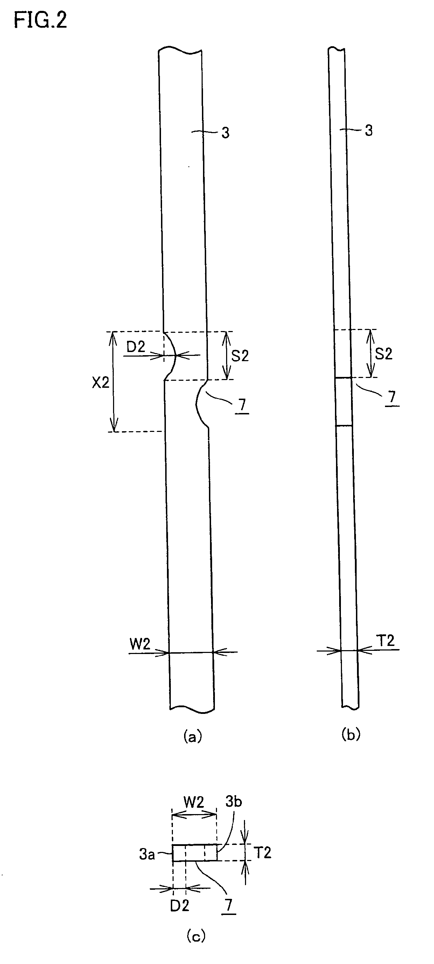

As shown in Fig. 2 (a), (b) and (c), small cross-section part 7 is formed by cutting out two opposite side surfaces 3a and 3b of conductive member 3 such that the side surfaces are curved alternately in the longitudinal direction with a dimension in the longitudinal direction of the interconnector of S2 and a dimension in the widthwise direction thereof of D2. Accordingly, a stress relief part X2 has its cross section whose cross-sectional area continuously changes in the longitudinal direction of the interconnector. Although Fig. 2 shows an example where the notches do not overlap in the longitudinal direction, the notches may partially overlap in the longitudinal direction.

Here, in the case where the conductive member is sheet-shaped and has its width W2 of approximately 2.5 mm and its thickness T2 of approximately 0.20 mm, it is particularly preferable that S2 is approximately 1 to 5 mm and D2 is approximately 0.5 to 1.5 mm. Preferably, a minimum width of small cross-section part 7 is approximately 0.5 to 1.5 mm.

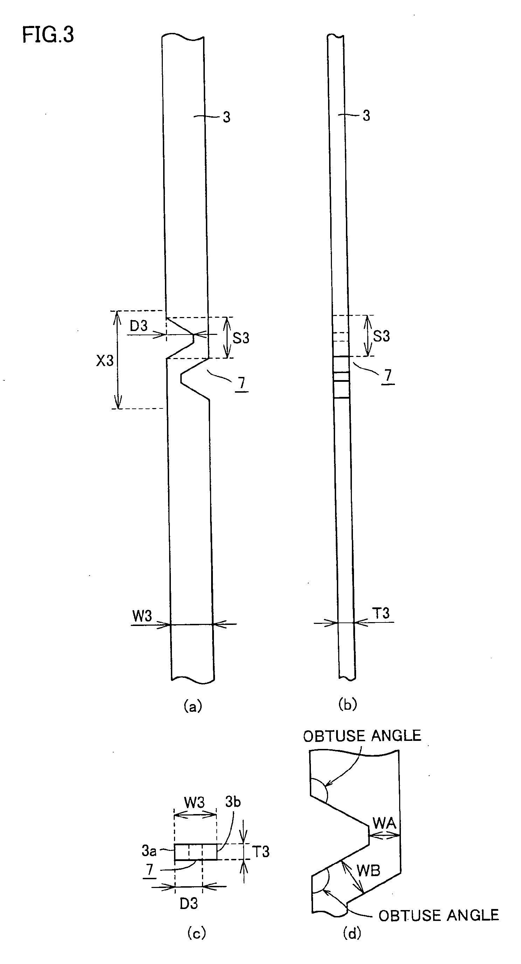

As shown in Fig. 3 (a), (b) and (c), small cross-section part 7 is formed by cutting out two opposite side surfaces 3a and 3b of conductive member 3 such that they are bend-shaped alternately in the longitudinal direction with a dimension in the longitudinal direction of the interconnector of S3 and a dimension in the widthwise direction thereof of D3. Accordingly, a stress relief part X2 has its cross section whose cross-sectional area continuously changes in the longitudinal direction of the interconnector.

Although Fig. 3 shows an example where the notches do not overlap in the longitudinal direction, the notches may partially overlap in the longitudinal direction. Although the shape of the notch is trapezoidal in Fig. 3, the notch may be curved at its corner. Further, trapezoidal notches have respective oblique sides so that small cross-section part 7 between the oblique sides extends in the same oblique direction with respect to the longitudinal direction. Since the notch is trapezoidal and the angle formed by the side surface of the conductive member and the oblique side of the trapezoidal notch is obtuse, the stress relief part of the interconnector has its structure unlikely to be caught on something. Specifically, in the case where the continuous interconnector is wound on a reel or unwound from the reel, or in the case where the interconnector is set for connecting the interconnector to a solar cell in a process of manufacturing a module, for example, interference between interconnectors and interference between an interconnector and another component can be avoided. In other words, damages such as deformation or breakage of the interconnector itself can be reduced or avoided that is caused by an excessive stress on the interconnector or a stress generated when the interconnector is caught before the interconnector is connected to a solar cell.

Here, in the case where the conductive member is sheet-shaped and has its width W3 of approximately 2.5 mm and its thickness T3 of approximately 0.20 mm, it is particularly preferable that S3 is approximately 1 to 5 mm and D3 is approximately 0.5 to 1.5 mm. Preferably, a minimum width of small cross-section part 7 is approximately 0.5 to 1.5 mm.

Preferably, width WB of the small cross-section part that is defined by the oblique sides facing each other of the opposite trapezoidal notches and width WA of the small cross-section part that is defined by the side surface of the strip-shaped conductive member and the upper side of the trapezoidal notch facing the side surface have the relation WB > WA. Thus, a plurality of (two in the present embodiment) small cross-section parts with width WA extend so that the interconnector can be easily changed in shape in the longitudinal direction and the extension can be dispersed over a plurality of portions. Further, since the interconnector in Fig. 3 is point-symmetric, the extension can be efficiently dispersed.

Here, all of stress relief parts X1 to X3 of the interconnectors in the embodiment shown in Figs. 1 to 3 have an obtuse angle formed by the notch and the lateral end. Thus, the stress relief part can be structured such that the stress relief part is unlikely to be caught on something.

As shown in Fig. 4 (a), (b) and (c), small cross-section part 7 is formed by cutting out two opposite side surfaces 3a and 3b of conductive member 3 in slit shapes formed alternately in the longitudinal direction and obliquely to the longitudinal direction and the slit-shaped notch has a round-shaped opening portion. Accordingly, a stress relief part X7 has its cross section whose cross-sectional area continuously changes in the longitudinal direction of the interconnector. Regarding this shape, although it is preferable that an end portion of the slit-shaped notch is curved in Fig. 4, the end portion of the notch may be rectangular in shape or the like. Further, it is preferable that respective directions of the slit-shaped notches are the same direction and small cross-section part 7 obliquely extends in the opposite direction with respect to the longitudinal direction.

Here, in the case where the conductive member is sheet-shaped and has its width W7 of approximately 2.5 mm and its thickness T7 of approximately 0.20 mm, it is particularly preferable that S7 is approximately 0.1 to 2 mm and D7 is approximately 1 to 2.0 mm. Preferably, a minimum width of small cross-section part 7 is approximately 0.5 to 1.5 mm.

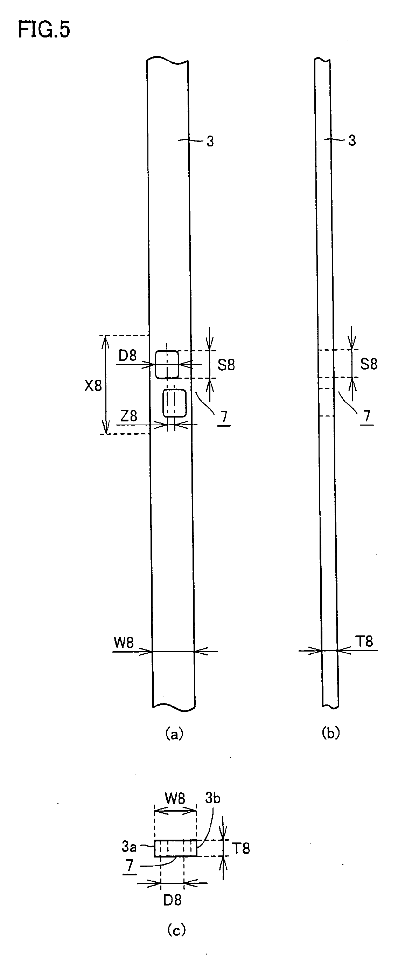

As shown in Fig. 5 (a), (b) and (c), small cross-section part 7 includes two notches in the longitudinal direction, the notches are formed by cutting out the inner plane of conductive member 3 in the shape of a rectangle with a dimension in the longitudinal direction of S8 and a dimension in the widthwise direction of D8, and the notches are displaced from each other in the widthwise direction. The rectangular notches are made in the inner plane of conductive member 3 to divide the interconnector. Accordingly, a stress relief part X8 has its cross section whose cross-sectional area dispersedly changes. In the case where a corner of the rectangular notch is curved, stress relief part X8 also has its cross section whose cross-sectional area continuously changes in the longitudinal direction of the interconnector.

In the interconnector shown in Fig. 5, two rectangular notches are cut out in the longitudinal direction from the inner plane of conductive member 3 and the notches are displaced from each other in the widthwise direction. However, the notches may be more than two. Further, the notches may not be displaced from each other in the widthwise direction. In the case where the notches are displaced from each other in the widthwise direction, a small cross-section part having a smaller cross-sectional area mainly extends in the longitudinal direction. Since the current path is a cross-sectional area portion having a larger cross-sectional area, change of the cross-sectional area due to extension is smaller and stable. Thus, the interconnector can efficiently collect generated electric power.

Here, in the case where the conductive member is sheet-shaped and, has its width W8 of approximately 2.5 mm and its thickness T8 of approximately 0.20 mm, it is particularly preferable that S8 is approximately 0.1 to 2 mm and D8 is approximately 1 to 2.0 mm. Preferably, Z8 is 0 to 0.5 mm and a minimum width of small cross-section part 7 is approximately 0.25 to 1.5 mm.

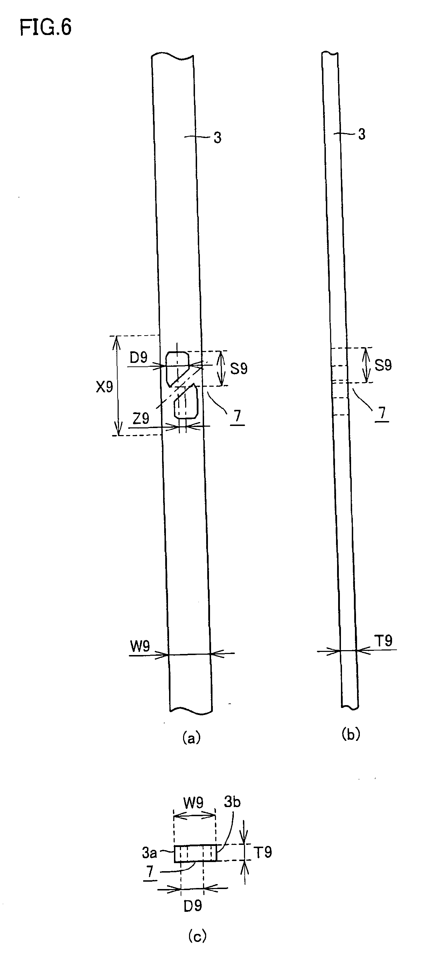

As shown in Fig. 6 (a), (b) and (c), small cross-section part 7 includes two notches in the longitudinal direction that are cut out in the shape of a trapezoid from an inner plane of conductive member 3 with a dimension in the longitudinal direction of the interconnector of S9 and a dimension in the widthwise direction of D9, and these notches are displaced from each other in the widthwise direction. Since the trapezoidal notches are provided in the inner plane of conductive member 3, the interconnector is divided and a stress relief part X9 has its cross section whose cross-sectional area dispersedly changes. Further, the oblique sides of the trapezoidal notches are inclined approximately 45 degrees with respect to the longitudinal direction and are disposed to face each other. Thus, stress relief part X9 also has its cross section whose cross-sectional area continuously changes in the longitudinal direction of the interconnector.

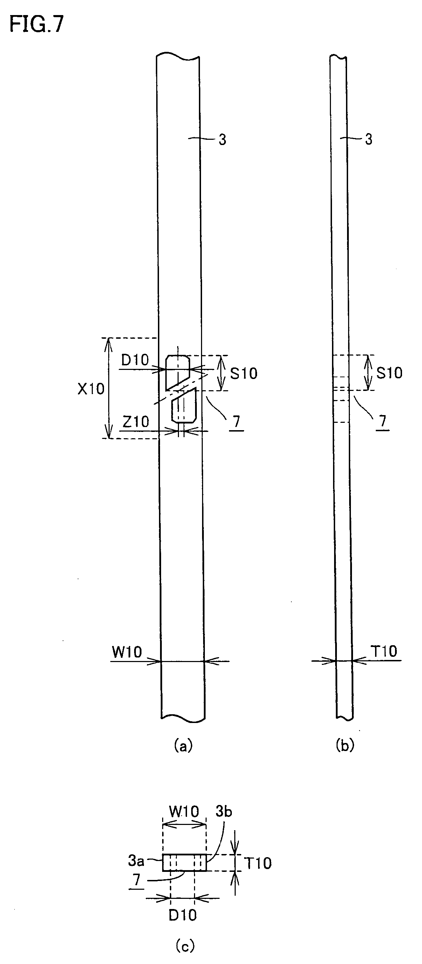

Fig. 6 shows that two trapezoidal notches that are cut out from the inner plane of conductive member 3 are disposed in the longitudinal direction and the trapezoidal notches are displaced from each other in the widthwise direction, and accordingly small cross-sectional area 7 is inclined with respect to the longitudinal direction. In the interconnector shown in Fig. 7, the oblique sides of the trapezoidal notches are inclined approximately 30 degrees with respect to the longitudinal direction, and the angle of inclination in this case may be set appropriately.

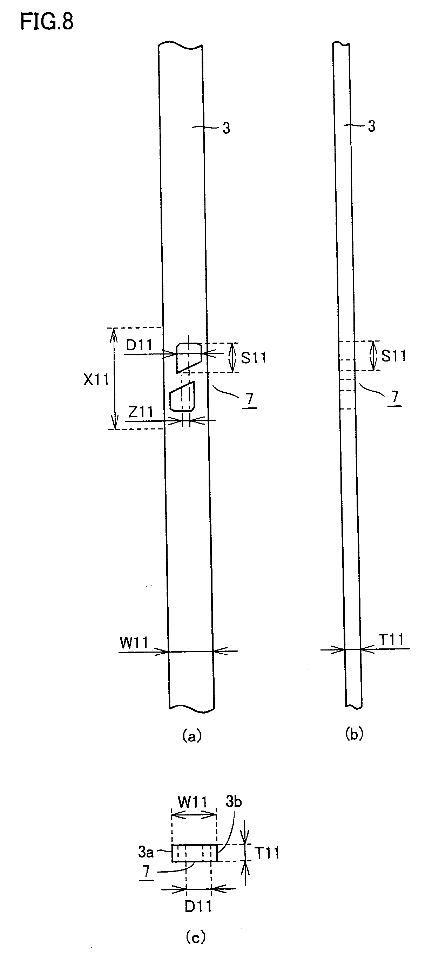

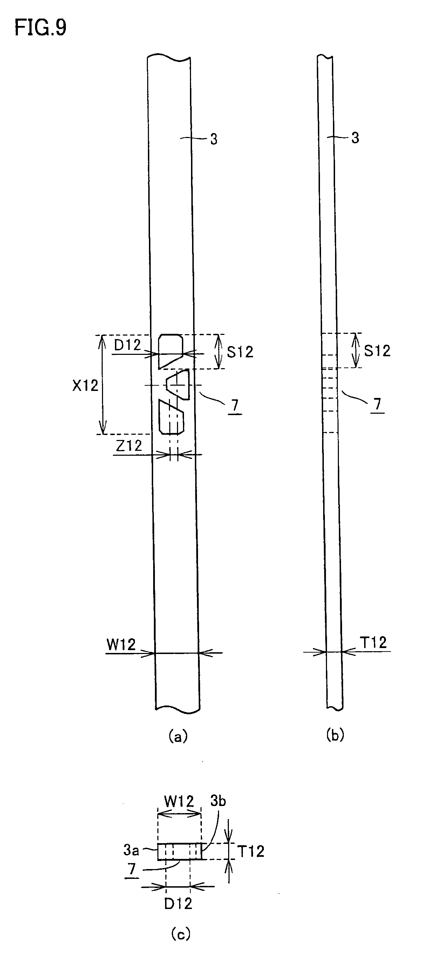

Further in the interconnector shown in Fig. 8, the trapezoidal notches are displaced in the widthwise direction in the opposite direction relative to the interconnector shown in Fig. 6, and accordingly small cross-section part 7 is inclined in the opposite direction with respect to the longitudinal direction. Furthermore, as shown in Fig. 9, the notches may be three or more and they may not be displaced from each other in the widthwise direction. Preferably a corner of the trapezoidal notches is curved in shape.

Here, in the case where the conductive member is sheet-shaped and has its width W9, W10, W11, W12 of approximately 2.5 mm and its thickness T9, T10, T11, T12 of approximately 0.20 mm, it is particularly preferable that S9, S 10, S11, S12 are approximately 0.1 to 3 mm and D9, D10, D11, D12 are approximately 1 to 2.0 mm. Preferably, Z9, Z10, Z11, Z12 are 0 to 0.5 mm and a minimum width of small cross-section part 7 is approximately 0.25 to 1.5 mm.

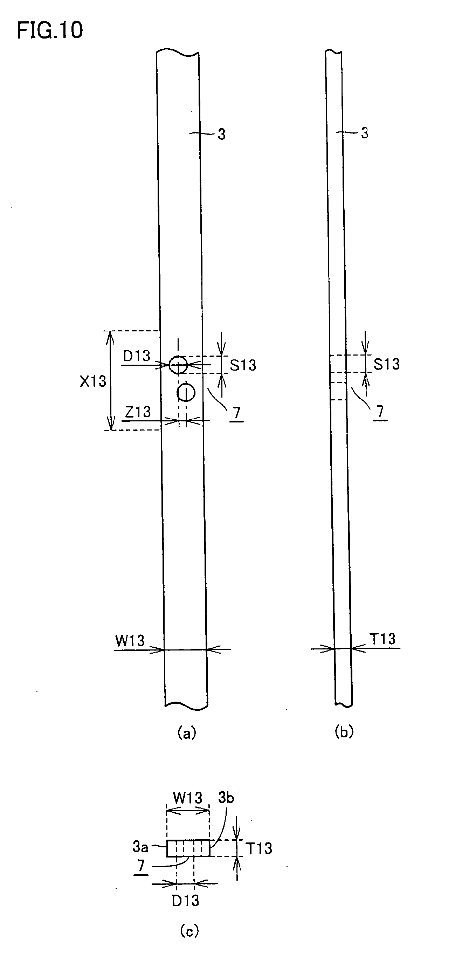

In the interconnector shown in Fig. 10 (a), (b) and (c), small cross-section part 7 includes two circular notches in the longitudinal direction that are cut out from the inner plane of conductive member 3 with a dimension in the longitudinal direction of the interconnector of S13 and a dimension in the widthwise direction of D13. Since circular notches are cut in the inner plane of conductive member 3, the interconnector is divided and accordingly a stress relief part X13 has its cross section whose cross-sectional area dispersedly changes. Further, the cross section of stress relief part X13 also has a cross-sectional area continuously changes in the longitudinal direction of the interconnector.

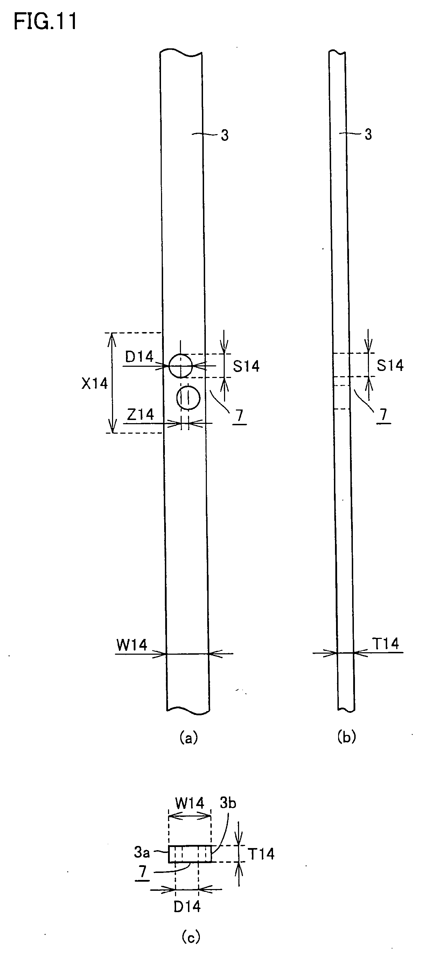

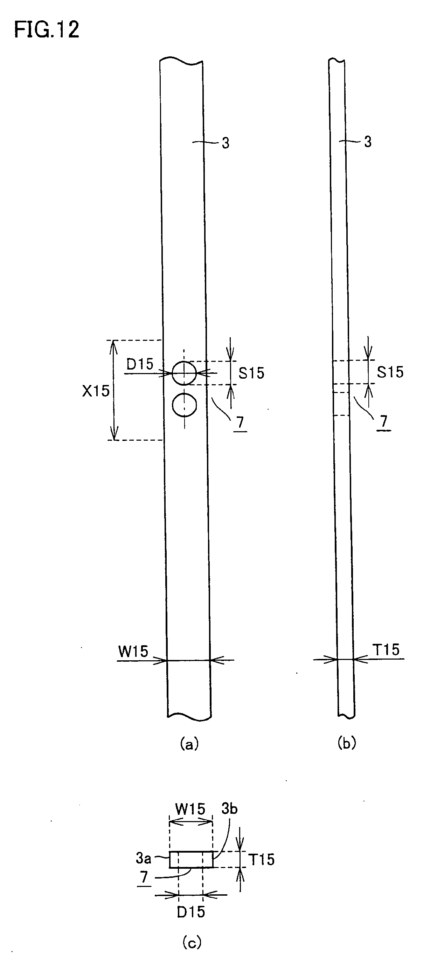

Notches may be displaced from each other in the widthwise direction like the interconnectors shown in Figs. 10 and 11 or disposed without displaced from each other in the widthwise direction as shown in Fig. 12. Further, notches may have an elliptical shape instead of the circular shape and the major axis may be oblique with respect to the longitudinal direction.

Here, in the case where the conductive member is sheet-shaped and has its width W13, W14, W15 of approximately 2.5 mm and its thickness T13, T14, T15 of approximately 0.20 mm, it is particularly preferable that S 13, S 14, S15 are approximately 1 to 3 mm and D 13, D 14, D 15 are approximately 1 to 2.0 mm. Preferably, Z 13, Z 14 are 0 to 0.5 mm and a minimum width of small cross-section part 7 is approximately 0.25 to 1.5 mm.

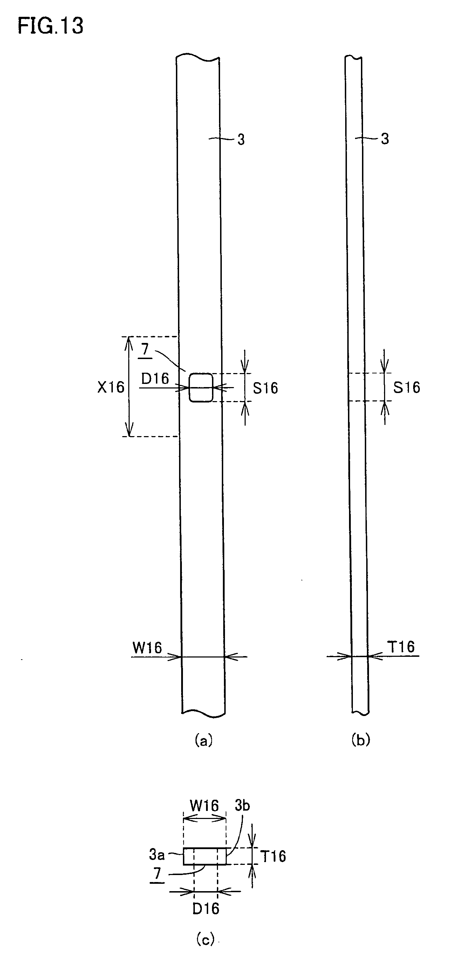

As shown Fig. 13 (a), (b) and (c), small cross-section part 7 includes one rectangular notch that is cut out from an inner plane of conductive member 3 with a dimension in the longitudinal direction of the interconnector of S16 and a dimension in the widthwise direction of D16. Since the rectangular notch is provided in the inner plane of conductive member 3, the interconnector is divided and a stress relief part X16 has its cross section whose cross-sectional area dispersedly changes.

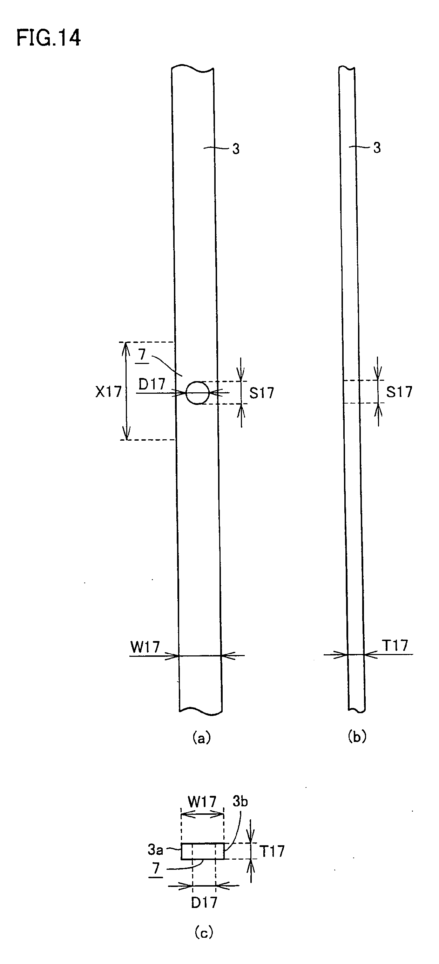

Further, as shown in Fig. 14 (a), (b) and (c), small cross-section part 7 includes one circular notch that is cut out from an inner plane of conductive member 3 with a dimension in the longitudinal direction of the interconnector of S 17 and a dimension in the widthwise direction of D17. Since the circular notch is provided in the inner plane of conductive member 3, the interconnector is divided and a stress relief part X16 has its cross section whose cross-sectional area changes dispersedly and continuously in the longitudinal direction of the interconnector. The notch may be elliptical instead of circular in shape, and the major axis of the ellipse may be oblique with respect to the longitudinal direction. Although Fig. 13 is used to describe the case where the main axis of the interconnector and the central axis of the notch overlap, the main axis of the interconnector and the central axis of the notch may be displaced from each other.

Here, in the case where the conductive member is sheet-shaped and has its width W16, W 17 of approximately 2.5 mm and its thickness T16, T 17 of approximately 0.20 mm, it is particularly preferable that S 16, S 17 are approximately 1 to 3 mm and D16, D 17 are approximately 1 to 2.0 mm. Preferably, a minimum width of small cross-section part 7 is approximately 0.25 to 1.25 mm.

According to another aspect, the present invention provides a solar cell string including solar cells adjacent to each other and having electrodes respectively and an interconnector electrically connecting respective electrodes of the solar cells adjacent to each other, and the interconnector is the above-described interconnector of the present invention. Regarding the above-described solar cell string of the present invention, preferably each solar cell is rectangular and has each side of 155 mm or more. Further, regarding the above-described solar cell string of the present invention, preferably each solar cell has its thickness of 300 µm or less.

Namely, as the solar cell is larger and thinner, the problem of the warp of the solar cell becomes conspicuous. The interconnector as described above of the present invention is used to effectively reduce the warp occurring when the interconnector is connected, and thus the productivity is improved.

According to still another aspect, the present invention provides a method of manufacturing the above-described solar cell string of the present invention, including the step of connecting an electrode of a solar cell and a connecting portion of the interconnector by means of any one of heater heating, lamp heating and reflow method.

With this manufacturing method, the electrode of the solar cell and the connecting portion of the interconnector are connected using a method which is any of heater heating, lamp heating and reflow method, so that the interconnector is joined to the whole surface of the electrode of the solar cell and thus the long-term reliability of the completed module can be improved.

According to still another aspect, the present invention provides a solar cell module including a solar cell string, an encapsulating material encapsulating the solar cell string and a pair of external terminals extending outward from the solar cell string through the encapsulating material, and the solar cell string is the above-described solar cell string of the present invention. The solar cell string is encapsulated in the encapsulating material to improve the environment resistance of the solar cell string. As the encapsulating material, for example, ethylene vinyl acetate copolymer is used.

The above-described solar cell module of the present invention may further include a surface protection layer of glass or polycarbonate on a light-receiving surface side and a rear film of PET (polyethylene terephthalate) on a rear side, and may further include a frame of aluminum around the module. Further, the solar cell module of the present invention may any of various solar cell modules such as roof tile integrated module, slate integrated module or see-through type module.

### First Embodiment

An interconnector according to a first embodiment of the present invention will be described with reference to Fig. 15.

Fig. 15 (a) is a plan view showing the interconnector according to the first embodiment of the present invention, Fig. 15 (b) and (c) are diagrams illustrating arrangement of electrodes on a light-receiving surface and a rear surface of solar cells, and Fig. 15 (d) is a diagram illustrating a state where the interconnector shown in Fig. 15 (a) is connected to light-receiving surface electrodes and rear electrodes of the solar cells shown in Fig. 15 (b) and (c).

Interconnector 1 shown in Fig. 15 (a) is made for example using an electrically conductive member (copper wire) that is solder-plated for example, and has a maximum width W1 (see Fig. 1 (a)) of 2.5 mm and a maximum thickness T1 (see Fig. 1 (c)) of 0.20 mm. As a material for the conductive member, any of other materials such as an alloy of copper-aluminum-copper or copper-Inver-copper may be used.

As shown in Fig. 15 (a), interconnector 1 includes a plurality of small cross-section parts 7. As shown in Fig. 1, for example, each small cross-section part 7 is formed by cutting each of two side surfaces 3a, 3b of conductive member 3 by approximately 0.75 mm in the width direction to form a curve. Small cross-section parts 7 are arranged at regular intervals P1 in the longitudinal direction of conductive member 3 correspondingly to a silver electrode of a light-receiving surface and a silver electrode of a rear surface of a predetermined solar cell while avoiding these silver electrodes. In the present embodiment, seven small cross-section parts 7 are formed in one interconnector 1, and interval P1 between the small cross-section parts 7 of for example 39.6 mm is used.

Fig. 15 (b) shows an example of a front electrode pattern of a crystalline silicon solar cell in the first embodiment of the present invention, and Fig. 15 (c) shows an example of a rear electrode pattern of the crystalline silicon solar cell in the first embodiment of the present invention. As shown in Fig. 15 (b), four gaps (non-connecting portions) 10a are provided around a central portion of a front electrode main grid so that the main grid is divided into five sections. The size of the gap (non-connecting portion) 10a in the first embodiment is for example approximately 9 mm x 4.5 mm. The width or size of the gap may be any as long as the gap is equal to or larger than width W1 of interconnector 1 and the stress relief part.

Further, as shown in Fig. 15 (c), the design is made such that a connecting portion where a rear side silver electrode of the solar cell and an interconnector are connected on the rear side and a connecting portion where a front side silver electrode and an interconnector are connected on the front side are symmetrical to each other, namely the connecting portions are arranged at respective positions corresponding to each other on the rear side and front side respectively. In the first embodiment, it is sufficient that the interval between silver electrodes 8b (width of 10b) on the rear side of the solar cell corresponds to gap (non-connecting portion) 10a. The interval is for example approximately 6 mm × 6 mm in size. The interval may have any width or size as long as the interval is equal to or larger than width W1 of interconnector 1 and the stress relief part.

Fig. 15 (d) shows the state where the interconnector is connected to the solar cell designed as described above. Fig. 15 (d) is a cross section showing the state where crystalline silicon solar cells in the first embodiment of the present invention are connected by the interconnector. At the gap portion provided in the front electrode main grid, the interconnector is not connected to the grid. At the gap portion, small cross-section part 7 (indicated by the arrow in Fig. 15 (d)) is disposed instead. Further, on the rear side, the interconnector and the solar cell are not soldered at aluminum electrode portion 6, and are soldered at only the silver electrode portion. This aluminum electrode is disposed at small cross-section part 7 of the interconnector.

Further, as shown in Fig. 15 (d), the connecting portion where the interconnector and the front silver electrode are connected on the front side and the connecting portion where the interconnector and the rear silver electrode are connected on the rear side are disposed at exactly the same position, and accordingly a stress caused by a difference in thermal expansion coefficient between the interconnector and the solar cell on the front side and that on the rear side are substantially equal to each other. Therefore, the stress due to a difference in thermal expansion coefficient between the cell and the interconnector that is one cause of occurrence of the warp of the solar cell is balanced between the front side and the rear side. Specifically, the above-described electrode pattern is provided and each small cross-section part 7 is disposed at the portion where each silver electrode and the interconnector are not connected, so that equal forces are applied to the solar cell from the front side and the rear side. With these effects, the warp of the solar cell is reduced and defective connection and occurrence of a cell crack can be prevented.

A process of connecting each silver electrode and the interconnector will be described. Solar cell 2 shown in Fig. 15 (d) is formed using a polycrystalline silicon substrate having a length of one side of 156.5 mm and a thickness of 200 µm for example, and the interval between a plurality of solar cells is 2 mm. As for the interconnector connecting a plurality of solar cells 2, an electrically conductive member is formed by covering a long and thin wire material made of copper for example with a solder and the conductive member stored in continuously reeled state is cut into pieces each having a length L1 of P1 × 7 = 277.2 mm (length L1 in Fig. 15 (a)) to be used as the interconnector. The interconnector in which stress relief parts are formed in advance may be stored in a reel, or stress relief parts may be formed when the interconnector is cut from the reel.

In the case where an interconnector in which stress relief parts are formed in advance is used, the interconnector may be cut at a position of a constant distance relative to a cut-out portion of the stress relief part and then used, because the stress relief parts are located at equal pitches. Supposing that the interconnector is cut in this manner, even if a trouble suddenly occurs in the amount of feed of the interconnector, the interconnector is cut in regular lengths after the portion of the interconnector where the trouble occurs. More specifically, since the stress relief parts are located at equal pitches, the position of the leading one of a plurality of cut-out portions may be simply identified to process the interconnector into interconnectors of the same length and the same shape, namely interconnectors having respective cut-out portions at the same position can be produced, as long as there is no problem in control of the feed amount. In the conventional example, once the position where the interconnector is to be cut is displaced, recovery is difficult and thus the cut-out portion where the interconnector should be cut has to be identified regularly, resulting in complicated control and management.

In the case where stress relief parts are formed after the interconnector is cut from the reel, cut-out portions may be formed at constant pitches from an endmost portion of the conductive member. For example, an electrically conductive member that is fed at a constant speed may be die-cut using a die for example, and complicated control and management are unnecessary.

Then, as shown in Fig. 15 (d), interconnectors 1 and solar cells 2 having a silver electrode are alternately transported and set. Specifically, a rear electrode 8b of solar cell 2 is laid on interconnector 1, another interconnector 1 is laid on a light-receiving surface electrode 8a of this solar cell 2, and a rear electrode 8b of another solar cell 2 is laid on this interconnector 1 successively. In the state where required interconnectors and required solar cells are arranged, heater heating for example is performed to solder interconnector 1 and each silver electrode and thereby connect the interconnector and the electrode. Specifically, the interconnector connected to the main grid of the light-receiving surface extends onto the rear surface of an adjacent cell and connected to the rear surface silver electrode. Here, small cross-section parts 7 that are a plurality of stress relief parts provided in interconnector 1 are each set corresponding to gap (non-connecting portion) 10a on the light-receiving surface side, and set corresponding to aluminum electrode portion 6 (10b) on the rear side. It should be noted that, in the present embodiment, interconnector 1 is not disposed at aluminum electrode portion 6 located on an end of interconnector 1 so that deterioration in power collection efficiency from the rear electrode is ignorable. In addition, aluminum electrode portion 6 may be provided on the central line of solar cell 2 in order that solar cell 2 may be divided into two portions for doubling the output voltage.

In this way, a solar cell string 22 with a small warp is completed where a plurality of solar cells 2 are connected electrically to each other in a line by interconnectors 1. Further, the interconnectors as shown in Figs. 1 to 4 can be used to reduce a contraction stress exerted on the cell when the temperature is lowered in the process of connecting the interconnector. Specifically, while the interconnector in the present embodiment is provided with a region where the proof strength is partially weak, the cross-sectional area of the region is continuously changed in the longitudinal direction of the interconnector such that local breakage due to stress concentration is avoided.

In particular, the interconnectors as shown in Figs. 5 to 12 can be used to reduce a contraction stress exerted on the cell when the temperature is lowered in the process of connecting the interconnector. Specifically, the interconnector is divided to have a cross-sectional area that changes dispersedly and the cross-sectional area that continuously changes in the longitudinal direction of the interconnector, in order to avoid local breakage due to stress concentration on the region of the interconnector where the proof strength is partially weak.

In particular, the interconnectors as shown in Figs. 13 and 14 can be used to reduce a contraction stress exerted on the cell when the temperature is lowered in the process of connecting the interconnector. Specifically, the interconnector is divided to have a cross-sectional area dispersedly changes in order to avoid local breakage due to stress concentration on the region of the interconnector where the proof strength is partially weak.

Further, in the case where the interconnectors as shown in Figs. 5 to 14 are used, the shape of the interconnector does not have any notch, at side surface portions 3a and 3b of conductive material 3, that is caught on something when the interconnector is fed in the process of connecting the interconnector and the solar cell. Therefore, the device transportation is facilitated and consequently the productivity can be improved.

With reference to Fig. 18, a solar cell module 23 using above-described solar cell string 22 will be described. As required, solar cell strings 22 are connected in series to each other using a relatively bold wire material called bus bar, and the cell strings thus connected are sandwiched between films of EVA (ethylene vinyl acetate) that is an encapsulating material 24, and thereafter sandwiched between a glass sheet that is a surface protection layer 25 and a back film that is a rear film 26 made of acrylic resin for example. Air bubbles entering between films are removed by decreasing the pressure (lamination) and heating (curing) is performed to harden the EVA and encapsulate solar cells 2. After this, an aluminum frame that is a frame 29 is fit on the four sides of the glass sheet, and a terminal box is connected to a pair of external terminals 27 and 28 extending outward from solar cell string 22. Thus, solar cell module 23 is completed.

Solar cell module 23 thus structured uses solar cell string 22 with a small warp, so that cracks of solar cells 2 are reduced in the encapsulation process with encapsulating material 24.

### Second Embodiment

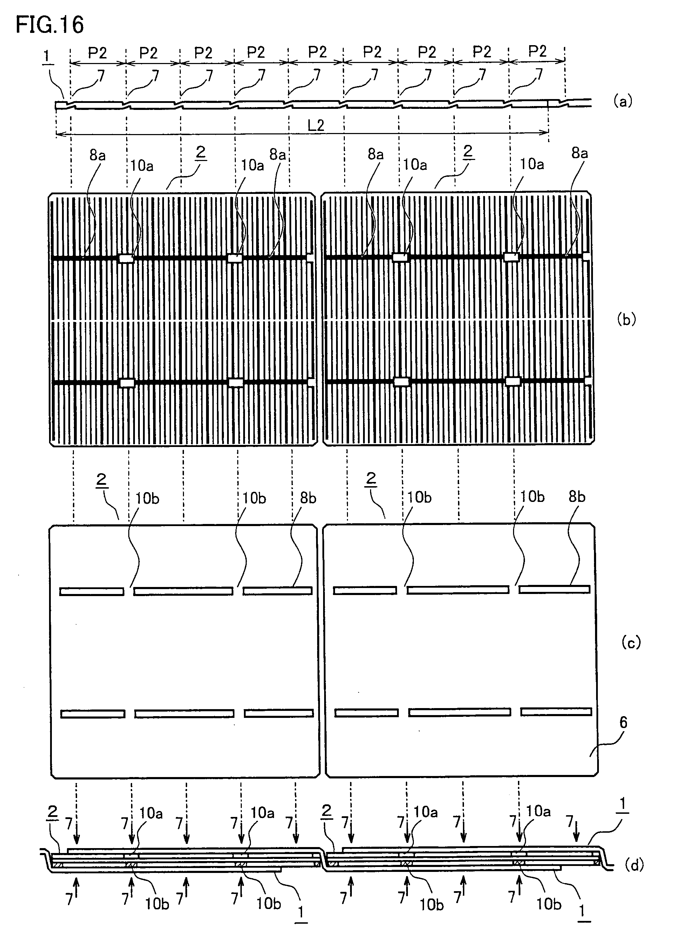

An interconnector according to a second embodiment of the present invention will be described with reference to Fig. 16. Fig. 16 (a) is a plan view showing the interconnector according to the second embodiment of the present invention, Fig. 16(b) and (c) are diagrams illustrating arrangement of electrodes on a light-receiving surface and a rear surface of solar cells, and Fig. 16 (d) is a diagram illustrating the state where the interconnector shown in Fig. 16 (a) is connected to light-receiving surface electrodes and rear electrodes of the solar cells shown in Fig. 16 (b) and (c).

Interconnector 1 shown in Fig. 16 (a) is made for example using an electrically conductive member 3 such as copper wire that is solder-plated for example, and has a maximum width W1 (see Fig. 1 (a)) of 2.5 mm and a maximum thickness T1 (see Fig. 1 (c)) of 0.20 mm. As a material for the conductive member, any of other materials such as an alloy of copper-aluminum-copper or copper-Inver-copper may be used instead of the copper wire.

As shown in Fig. 16 (a), interconnector 1 includes a plurality of small cross-section parts 7. As shown in Fig. 1, for example, each small cross-section part 7 is formed by cutting each of two side surfaces 3a, 3b of conductive member 3 by approximately 0.75 mm in the width direction to form a curve. Small cross-section parts 7 are arranged at regular intervals P2 in the longitudinal direction of conductive member 3 correspondingly to a silver electrode of a light-receiving surface and a silver electrode of a rear surface while avoiding these silver electrodes. In the present embodiment, nine small cross-section parts 7 are formed in one interconnector 1, and interval P2 between the small cross-section parts 7 is for example 31.7 mm.

Fig. 16 (b) shows an example of a front electrode pattern of a crystalline silicon solar cell in the second embodiment of the present invention, and Fig. 16 (c) shows an example of a rear electrode pattern of the crystalline silicon solar cell in the second embodiment of the present invention. As shown in Fig. 16 (b), two gaps (non-connecting portions) 10a are provided around a central portion of a front electrode main grid so that the main grid is divided into three sections. The size of the gap (non-connecting portion) 10a in the second embodiment is for example approximately 9 mm

Further, as shown in Fig. 16 (c), the design is made such that a connecting portion where a rear side silver electrode and an interconnector are connected on the rear side and a connecting portion where a front side silver electrode and an interconnector are connected on the front side are symmetrical to each other. In the second embodiment, it is sufficient that the interval between silver electrodes 8b (width of 10b) on the front side of the solar cell corresponds to gap 10a (non-connecting portion). The interval is for example approximately 6 mm × 6 mm in size. The interval may have any width or size as long as the interval is equal to or larger than width W1 of interconnector 1 and the stress relief part.

Fig. 16 (d) shows the state where the interconnector is connected to the solar cell designed as described above. Fig. 16 (d) is a cross section showing the state where crystalline silicon solar cells in the second embodiment of the present invention are connected by the interconnector. At the gap portion provided in the front electrode main grid, the interconnector is not connected to the grid. At the gap portion, small cross-section part 7 (indicated by the arrow in Fig. 16 (d)) of the interconnector is disposed instead. Further, on the rear side, the interconnector and the solar cell are not soldered at aluminum electrode portion 6, and are soldered at only the silver electrode portion. This aluminum electrode is disposed at small cross-section part 7 of the interconnector.

Further, as shown in Fig. 16 (d), the portion where the interconnector and the front silver electrode are connected on the front side and the portion where the interconnector and the rear silver electrode are connected on the rear side are disposed at exactly the same position, and accordingly a stress caused by a difference in thermal expansion coefficient between the interconnector and the solar cell on the front side and that on the rear side are substantially equal to each other. Therefore, the stress due to a difference in thermal expansion coefficient between the cell and the interconnector that is one cause of occurrence of the warp of the solar cell is balanced between the front side and the rear side. Specifically, the above-described electrode pattern is provided and each small cross-section part 7 is disposed at the portion where each silver electrode and the interconnector are not connected, so that equal forces are applied to the solar cell from the front side and the rear side. With these effects, the warp of the solar cell is reduced and defective connection and occurrence of a cell crack can be prevented.

A process of connecting each silver electrode and the interconnector will be described. Solar cell 2 shown in Fig. 16 (d) is formed using a polycrystalline silicon substrate having one side of 156.5 mm and a thickness of 200 µm for example, and the interval between a plurality of solar cells 2 is 2 mm. As for the interconnector connecting a plurality of solar cells 2, an electrically conductive member is formed by covering a long and thin wire material made of copper for example with a solder and the conductive member stored in continuously reeled state is cut into pieces each having a length L2 of P2 x 9 = 285.3 mm to be used as the interconnector as designed. The interconnector in which stress relief parts are formed in advance may be stored in a reel, or stress relief parts may be formed when the interconnector is cut from the reel. In the case where an interconnector in which stress relief parts are formed in advance is used, the interconnector may be cut at a position of a constant distance relative to a cut-out portion of the stress relief part and then used, because the stress relief parts are located at equal pitches. Even if a trouble suddenly occurs in the amount of feed of the interconnector, the interconnector is cut in regular lengths after the portion of the interconnector where the trouble occurs. More specifically, since the stress relief parts are arranged at regular pitches, the position of the leading one of a plurality of cut-out portions may be simply identified to process the interconnector into interconnectors of the same length and the same shape (having respective cut-out portions at the same position), as long as there is no problem in control of the feed amount. In the conventional example, once the position where the interconnector is to be cut is displaced, recovery is difficult and thus the cut-out portion where the interconnector should be cut has to be identified regularly, resulting in complicated control and management.

In the case where small cross-section parts are formed after the interconnector is cut from the reel, cut-out portions may be formed at constant pitches from an endmost portion of the conductive member. For example, an electrically conductive member that is fed at a constant speed may be die-cut using a die for example, and complicated control and management are unnecessary.

Then, as shown in Fig. 16 (d), interconnectors 1 and solar cells 2 having a silver electrode are alternately transported and set. Specifically, a rear electrode 8b of solar cell 2 is laid on interconnector 1, another interconnector 1 is laid on a light-receiving surface electrode 8a of this solar cell 2, and a rear electrode 8b of another solar cell 2 is laid on this interconnector 1 successively. In the state where required interconnectors and required solar cells are arranged, heater heating for example is performed to solder interconnector 1 and each silver electrode and thereby connect the interconnector and the electrode. Specifically, the interconnector connected to the main grid of the light-receiving surface extends onto the rear surface of an adjacent cell and connected to the rear surface silver electrode.

Here, regarding a plurality of small cross-section parts 7 provided to interconnector 1, small cross-section parts on the light-receiving surface side are set such that the second and fourth small cross-section parts 7 counted with respect to one end are set correspondingly to gaps 10a that are non-connecting portions, and small cross-section parts on the rear side are set such that the first and third small cross-section parts 7 counted with respect to the other end are set correspondingly to aluminum electrode portion 6 (10b). In other words, small cross-section parts 7 other than the second and forth small cross-section parts 7 counted with respect to one end on the light-receiving surface side and first and third small cross-section parts 7 counted with respect to the other end on the rear side are soldered to each electrode and effectively do not serve as a stress relief. Therefore, the stress relief part is determined depending on the position where gap (non-connecting portion) 10a and aluminum electrode portion 6 (10b) are arranged.

In this way, a solar cell string 22 with a small warp is completed where a plurality of solar cells 2 are connected electrically to each other in a line by interconnectors 1. Methods of manufacturing the interconnector used in the present embodiment as well as the solar cell module using the solar cell string in the present embodiment follow those in the first embodiment.

### Third Embodiment

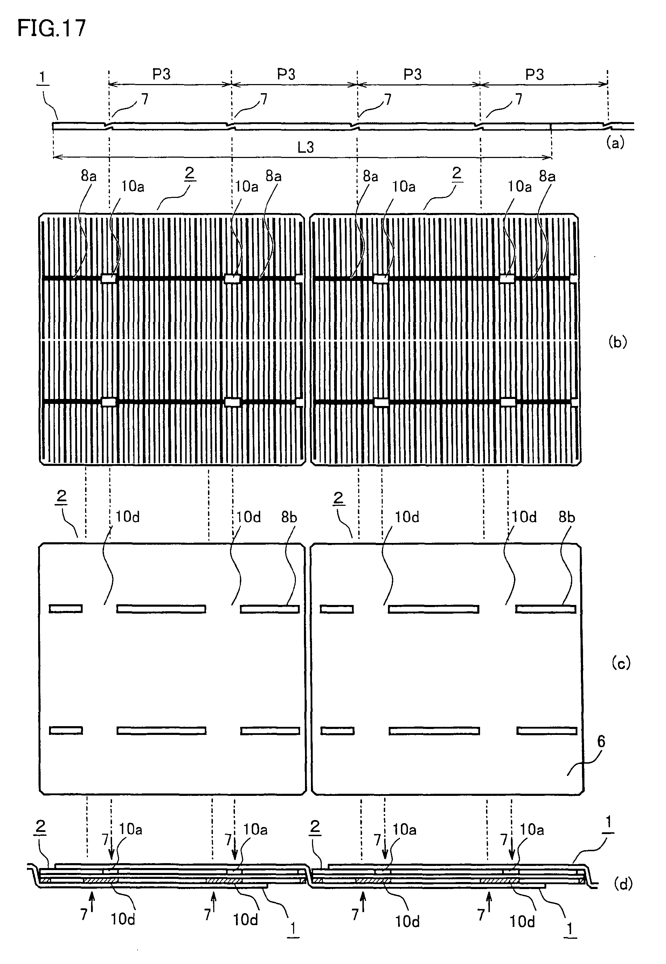

An interconnector according to a third embodiment of the present invention will be described with reference to Fig. 17. Fig. 17 (a) is a plan view showing the interconnector according to the third embodiment of the present invention, Fig. 17 (b) and (c) are diagrams illustrating arrangement of electrodes on a light-receiving surface and a rear surface of solar cells, and Fig. 17 (d) is a diagram illustrating the state where the interconnector shown in Fig. 17 (a) is connected to light-receiving surface electrodes and rear electrodes of the solar cells shown in Fig. 17 (b) and (c).

Interconnector 1 shown in Fig. 17 (a) is made for example using an electrically conductive member (copper wire) 3 that is solder-plated for example, and has a maximum width W1 (see Fig. 1 (a)) of 2.5 mm and a maximum thickness T1 (see Fig. 1 (c)) of 0.20 mm. In the present embodiment as well, as a material for the conductive member, any of other materials such as an alloy of copper-aluminum-copper or copper-Inver-copper may be used instead of the copper wire.

As shown in Fig. 17 (a), interconnector 1 includes a plurality of small cross-section parts 7. As shown in Fig. 1, for example, each small cross-section part 7 is formed by cutting each of two side surfaces 3a, 3b of conductive member 3 by approximately 0.75 mm in the width direction to form a curve. Small cross-section parts 7 are arranged at regular intervals P3 in the longitudinal direction of conductive member 3 correspondingly to a silver electrode of a light-receiving surface and a silver electrode of a rear surface of a predetermined solar cell while avoiding these silver electrodes. In the third embodiment, interval P3 is 73.0 mm for example, and interconnector 1 has four small cross-section parts 7.

Fig. 17 (b) shows an example of a front electrode pattern of a crystalline silicon solar cell in the third embodiment of the present invention, and Fig. 17 (c) shows an example of a rear electrode pattern of the crystalline silicon solar cell in the third embodiment of the present invention. As shown in Fig. 17 (b), two gaps (non-connecting portions) 10a are provided around a central portion of a front electrode main grid so that the main grid is divided into three sections. The size of gap 10a that is a non-connecting portion in the third embodiment is for example approximately 9 mm x 4.5 mm. The width or size of the gap may be any as long as the gap is equal to or larger than width W1 of interconnector 1 and the stress relief part.

Further, as shown in Fig. 17 (c), the design is made such that a connecting portion where a rear side silver electrode and an interconnector are connected on the rear side and a connecting portion where a front side silver electrode and an interconnector are connected on the front side are arranged at respective positions symmetrical to each other. In the third embodiment, the interval between silver electrodes 8b (width of 10b) on the front side may be any as long as the interval is equal to or larger than a region corresponding to gap (non-connecting portion) 10a. The magnitude of the interval is approximately 20 mm x 6 mm for example. The width or size of the interval may be any as long as the interval is equal to or larger than width W1 and the stress relief part.

Fig. 17 (d) shows the state where the interconnector is connected to solar cells designed as described above. Fig. 17 (d) is a cross section showing the state where crystalline silicon solar cells in the third embodiment of the present invention are connected by the interconnector. At the gap portion provided in the front electrode main grid, the interconnector is not connected to the grid. At the gap portion, small cross-section part 7 (indicated by the arrow in Fig. 17 (d)) is disposed instead. Further, on the rear side, the interconnector and the solar cell are not soldered at aluminum electrode portion 6, and are soldered at only the silver electrode portion. This aluminum electrode is disposed at small cross-section part 7 of the interconnector.

Further, as shown in Fig. 17 (d), the portion where the interconnector and the front silver electrode are connected on the front side and the portion where the interconnector and the rear silver electrode are connected on the rear side are disposed at respective positions overlapping each other on the front side and the rear side respectively, and accordingly a stress caused by a difference in thermal expansion coefficient between the interconnector and the solar cell on the front side and that on the rear side are substantially equal to each other. Therefore, the stress due to a difference in thermal expansion coefficient between the cell and the interconnector that is one cause of occurrence of the warp of the solar cell is balanced between the front side and the rear side. Specifically, the above-described electrode pattern is provided and each small cross-section part 7 is disposed at the portion where each silver electrode and the interconnector are not connected, so that equal forces are applied to the solar cell from the front side and the rear side. With these effects, the warp of the solar cell is reduced and defective connection and occurrence of a cell crack can be prevented.

A process of connecting each silver electrode and the interconnector in the present embodiment will be described. Solar cell 2 shown in Fig. 17 (d) is formed using a polycrystalline silicon substrate having one side of 156.5 mm and a thickness of 200 µm for example, and the interval between a plurality of solar cells is 2 mm. As for the interconnector connecting a plurality of solar cells 2, an electrically conductive member is formed by covering a long and thin wire material made of copper for example with a solder and the conductive member stored in continuously reeled state is cut into pieces each having a length L3 of P3 x 4 = 292 mm for example to be used as the interconnector.

The interconnector in which stress relief parts are formed in advance may be stored in a reel, or stress relief parts may be formed when the interconnector is cut from the reel. In the case where an interconnector in which stress relief parts are formed in advance is used, the interconnector may be cut at a position of a constant distance relative to a cut-out portion of the stress relief part and then used, because the stress relief parts are located at equal pitches. Even if a trouble suddenly occurs in the amount of feed of the interconnector, the interconnector is cut in regular lengths after the portion of the interconnector where the trouble occurs. More specifically, since the stress relief parts are arranged at equal pitches, the position of the leading one of a plurality of cut-out portions may be simply identified to process the interconnector into interconnectors of the same length having respective cut-out portions of the same shape at the same position, as long as there is no problem in control of the amount of feed of the interconnector. In the conventional example, once the position where the interconnector is to be cut is displaced, recovery is difficult and thus the cut-out portion where the interconnector should be cut has to be identified regularly, resulting in complicated control and management.

In the case where stress relief parts are formed after the interconnector is cut from the reel, cut-out portions may be formed at constant pitches from an endmost portion of the conductive member. For example, an electrically conductive member that is fed at a constant speed may be die-cut using a die for example, and complicated control and management are unnecessary.

Then, as shown in Fig. 17 (d), interconnectors 1 and solar cells 2 having a silver electrode are alternately transported and set. Specifically, a rear electrode 8b of solar cell 2 is laid on interconnector 1, another interconnector 1 is laid on a light-receiving surface electrode 8a of this solar cell 2, and a rear electrode 8b of another solar cell 2 is laid on this interconnector 1 successively. In the state where required interconnectors and required solar cells are arranged, heater heating for example is performed to solder interconnector 1 and each silver electrode and thereby connect the interconnector and the electrode. Specifically, the interconnector connected to the main grid of the light-receiving surface extends onto the rear surface of an adjacent cell and connected to the rear surface silver electrode. Here, small cross-section parts 7 that are a plurality of stress relief parts provided to interconnector 1 are each set correspondingly to gap (non-connecting portion) 10a on the light-receiving surface side and set correspondingly to aluminum electrode portion 6 (10b) on the rear surface side. In this way, a plurality of solar cells 2 are electrically connected to each other in line by interconnector 1 and accordingly solar cell string 22 with small warp is completed.

Methods of manufacturing the interconnector used in the present embodiment as well as the solar cell module using the solar cell string in the present embodiment follow those in the first embodiment.

It should be construed that embodiments disclosed above are by way of illustration in all respects, not by way of limitation. It is intended that the scope of the present invention is defined by claims, not by the embodiments and examples above, and includes all modifications and variations equivalent in meaning and scope to the claims.

## Claims

1. An interconnector connecting solar cells including an electrode formed on a front surface or rear surface of a semiconductor substrate,
said interconnector comprising a strip-shaped and electrically conductive member electrically connecting respective electrodes to each other of adjacent solar cells, and
said conductive member including a plurality of planar stress relief parts, said stress relief parts being formed at regular intervals from one end to the other end of said conductive member.

2. The interconnector according to claim 1, wherein
said electrode is formed from one end side to an opposite end side of said semiconductor substrate in a direction in which the adjacent solar cells are connected to each other, and
said conductive member is connected to said electrode from the one end side to the opposite end side of the semiconductor substrate in the direction in which the adjacent solar cells are connected to each other.

3. The interconnector according to claim 1, wherein
said electrode extends in a direction in which the adjacent solar cells are connected to each other, gaps are provided at predetermined intervals, and said stress relief parts of said conductive member are connected to said gaps.

4. The interconnector according to claim 3, wherein
said electrode is formed of a silver electrode, and an aluminum electrode is formed on said rear surface of said semiconductor substrate and in a region except for a region where said silver electrode is formed.

5. The interconnector according to claim 4, wherein
said aluminum electrode is formed on said rear surface of said semiconductor substrate and in a region including a central line of said solar cell extending in a direction in which said adjacent solar cells are connected.

6. The interconnector according to claim 1, wherein
said stress relief parts each include a small cross-section part formed by a pair of curved notches located opposite to each other and formed at respective lateral sides opposite to each other of said conductive member.

7. The interconnector according to claim 1, wherein
said stress relief parts each include a small cross-section part formed by a notch formed by being cut out from an inner plane of said conductive member.

8. A solar cell string comprising solar cells including respective electrodes and adjacent to each other and the interconnector as recited in any of claims 1 to 7 and electrically connecting respective electrodes to each other of said solar cells adjacent to each other.

9. A method of manufacturing the solar cell string as recited in claim 8, comprising the step of connecting an electrode of a solar cell and the interconnector by any one of heater heating, lamp heating and reflow method.

10. A solar cell module comprising:
the solar cell string as recited in claim 8;
an encapsulating material encapsulating said solar cell string; and
a pair of external terminals extending outward from said solar cell string through the encapsulating material.
